# EUROPEAN PATENT APPLICATION

(11) **EP 2 746 800 A1**
(43) Date of publication of application: **25.06.2014**
(21) Application number: 13197352.1
(22) Date of filing: 16.12.2013
(51) Int. Cl.: G01R 33/48, G01T 1/16, G01R 33/3875, G01R 33/421, G01R 33/385

(54) **Molecular gradient coil for hybrid SPECT-MRI imaging system**

(30) Priority: 20.12.2012 EP 12198314
(71) Applicant: Universiteit Gent, 9000 Gent (BE); iMinds VZW, 9050 Gent (BE)
(72) Inventor: Van Holen, Roel, 9000 Gent (BE); Vandenberghe, Stefaan, 9860 Oosterzele (BE)
(74) Representative: Jacobs, Philippe

(57) **Abstract**

A detection device for hybrid detection of photons, the detection device comprising a molecular gradient coil and at least one molecular imaging device, for instance a SPECT imaging device, the molecular gradient coil being a split molecular gradient coil (6) comprising at least two axial parts and the at least one molecular imaging device being disposed in the gap between the at least two parts of the split molecular gradient coil.

## Description

### Field of the invention

The present invention relates to the field of imaging especially medical imaging. More particularly, the present invention relates to the field of hybrid Single Photon Emission Computed Tomography (SPECT) and Magnetic Resonance Imaging (MRI) imaging systems, methods and software.

### Background of the invention

### SPECT

Single Photon Emission Computed Tomography (SPECT) is a medical imaging technique used for visualisation of the functioning of the body in vivo.

A SPECT imaging system typically uses a detection device known as a gamma camera to produce images. A conventional gamma camera consists of two main functional components, being the collimator and the radiation detector. A radiation detector is essential to absorb and measure the γ-rays (photons) that escape the body of interest. To obtain 3D images, reconstruction techniques are used that start from projection data. The direction of the photon can usually not be determined however from the detection itself. Therefore, typically a mechanical collimator is needed. A traditional SPECT imaging system often uses a parallel-hole collimator, i.e. a slab perforated with small parallel holes made of heavy material such as for instance lead. These holes define a possible line of origin, perpendicular to the place of interaction on the detector. All holes together define a parallel beam through which photons are detected. This enables reconstruction from projections, acquired under different angles. Besides parallel-hole collimators, other types of collimators can be used, such as for instance pinhole, multi-pinhole, slit, slat, fan-beam or cone-beam collimators, depending on the required sensitivity and spatial resolution for a certain field-of-view.

Sensitivity of a system as used in this application is defined by the fraction of emitted photons that are detected by the system.

Collimators impose a fundamental burden on SPECT imaging systems, namely the trade-off between spatial resolution and sensitivity. The better the desired resolution, the smaller the collimator apertures have to be, with a resulting lower fraction of the emitted photons being detected. The sensitivity for an acceptable resolution is usually as low as 0.01-0.1% in current clinical and pre-clinical SPECT imagers. This low sensitivity requires a high radiation dose, a longer scan time, increased noise in reconstructed images, or a combination of these, which is not desired.

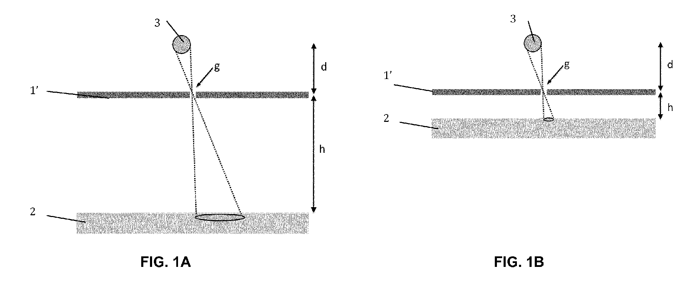

Pinhole SPECT systems typically work in magnification mode (FIG. 1A). Basically this means that they operate according to the camera obscura principle. One of the reasons for the choice for magnification is that these systems are all based on large detectors for clinical systems with relatively poor resolution. Due to the magnification of the object under study (source) onto the detector, the detector spatial resolution has a limited effect on the final resolution or, in other words, the level of detail in the reconstructed image. Next to spatial resolution, sensitivity is of equal importance for a SPECT system. The sensitivity is defined by the ratio of the number of detected gamma rays to the number of emitted gamma rays. Sensitivity is a key parameter in SPECT system design as a low sensitivity results in noisy images that are difficult to interpret. High sensitivity can be obtained by increasing the number of pinholes and by using detectors with sufficient thickness and stopping power.

Rogulski et al. described an imaging system that works in minification mode, as can be seen on FIG. 1B. In minification mode, the detector spatial resolution becomes of extreme importance, see M.M. Rogulski et al. Ultra-high-resolution brain SPECT imaging: simulation results IEEE Transaction on Nuclear Science 1993 Vol. 40:1123-9.

### MRI

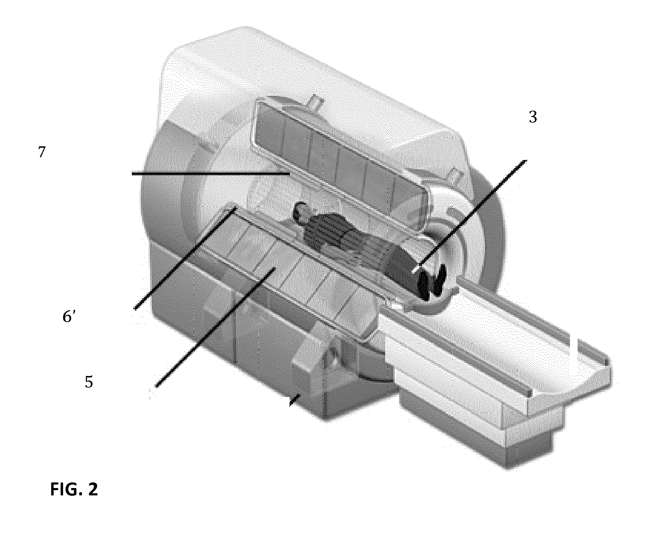

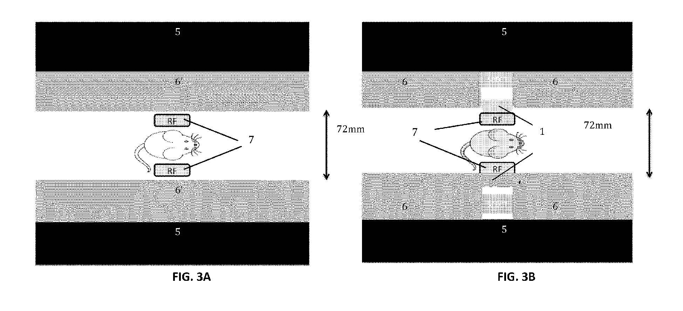

Magnetic resonance imaging (MRI) is a powerful in vivo imaging technique for imaging the structure or anatomy of the body. An MRI scanner typically consists of a main superconducting magnet for producing the high stationary and uniform magnetic field (typically 1.5T, 3T or 7T) within the central opening or bore of the scanner. Inside this main magnet, field gradient coils are placed for the purpose of three-dimensional imaging. This coil array usually has a cylindrical shape and decreases the initial diameter of the bore to a smaller value. A third important component of an MRI coil is the send/receive coil or RF coil that is used to excite the protons and sequentially, to pick up their response signal. A schematic view of the different parts of an MRI scanner can be found on FIG. 3A and FIG. 2.

### Hybrid Imaging

Compared to stand-alone Positron Emission Tomography (PET), stand-alone Computed Tomography (CT), or the retrospective co-registration of functional and anatomical patient images, hybrid PET/CT has been proven advantageous. Since 1998, combined PET/CT shows better diagnostic accuracy, not only for tumor staging and therapy monitoring in oncology (e.g. [1]), but also in cardiovascular disease (e.g. [2]). The commercial introduction of PET/CT was soon followed by the integration of Single Photon Emission Computed tomography (SPECT) and CT with proven advantages in oncologic, neurologic and cardiac applications ([3] and references therein). Over PET/CT, SPECT/CT offers the advantage of much lower cost, longer tracer half-lives, higher tracer specific activities, and better spatial resolution in pre-clinical context. On the other hand, SPECT/CT suffers from low sensitivity compared to PET/CT [4].

In clinics, Magnetic Resonance Imaging (MRI) has recently been combined with PET by the three main vendors (GE, Siemens and Philips). The development of clinical PET/MRI was inspired by the pioneering work of Simon Cherry's research group who saw a need for improved soft-tissue contrast with regard to pre-clinical CT [5]. Due to enhanced contrast in soft-tissue such as the brain, the advantages of PET/MRI are believed to bring a better understanding, mainly in the field of neurology [6].

Next to the superior soft-tissue contrast, MRI has no proven biological effects and allows for sequence optimization depending on the imaging task. An excellent overview of PET/MRI is given by Pichler [7].

As far as is known, no commercial systems have been developed for hybrid SPECT/MRI and the current state-of-the-art in SPECT/MRI is limited to research that has combined microSPECT with MRI. Two approaches follow a sequential design ([8] and [9]). Other approaches allow a simultaneous, pre-clinical SPECT/MRI system ([10], [11], [12]). The SPECT system described in [10] requires rotation of the SPECT detector and/or collimator to obtain enough projections of the object to reconstruct the image. Rotation of the SPECT detector and/or collimator requires re-shimming of the magnetic field generated by the main magnet. The SPECT system described in [11] en [12] are SPECT systems which allow to obtain respectively 24 and 32 views of the object simultaneously without rotation of the SPECT detector and/or the collimator. To reconstruct a SPECT image with sufficient spatial resolution, more projections are needed, requiring a rotation of the SPECT detector and/or collimator. Rotation of the SPECT detector and/or collimator again requires re-shimming of the magnetic field generated by the main magnet, which is not desired.

### REFERENCES

[1] G. Antoch et al. Accuracy of whole-body dual-modality fluorine-18-2-fluoro-2-deoxy-D-glucose positron emission tomography and computed tomography (FDG-PET/CT) for tumor staging in solid tumors: comparison with CT and PET. J Clin Oncol 2004 Vol.22:4357-68.
[2] O. Gaemperli et al. PET and PET/CT in cardiovascular disease PET/CT APPLICATIONS IN NON-NEOPLASTIC CONDITIONS 2011 Book Series: Annals of the New York Academy of Sciences Vol.: 1228:109-36
[3] B.Bybel et al. SPECT/CT Imaging: Clinical Utility of an Emerging Technology RadioGraphics 2008 Vol.28:1097-113.
[4] A. A. Lammertsma PET/SPECT: functional imaging beyond flow Vision Research 2001 Vol.41:1277-81
[5] Y. Shao et al. Simultaneous PET and MR imaging Phys Med Biol 1997 Vol.42:1965-70.
[6] W.D. Heiss et al. The potential of PET/MR for brain imaging Eur J Nucl Med Mol Imaging 2009 Vol.36(suppl 1):S105-S112.
[7] Bernd J. Pichler et al. PET/MRI: Paving the Way for the Next Generation of Clinical Multimodality Imaging Applications J Nucl Med 2010 Vol.51:333-6
[8] G. Christian et al. SPECT low-field MRI system for small-animal imaging J Nucl Med 2008n Vol.49(1):88-93
[9] J. Xu et al. SPECT data acquisition and image reconstruction in a stationary small animal SPECT/MRI system. Proc. SPIE 2010 7622, 76220V
[10] M.J. Hamamura et al. Development of an MR-compatible SPECT system (MRSPECT) for simultaneous data acquisition Phys Med Biol 2010 Vol.55(6):1563-75
[11] D.J. Wagenaar et al. A stationary SPECT system for simultaneous MRI/SPECT dual-modality pre-clinical imaging. Proc. Intl. Soc. Mag. Reson. Med. 17 (2009)
[12] D. Meier et al. A SPECT camera for simultaneous SPECT/MRI. IEEE 2009 2313-2318

### Summary of the invention

It is an object of embodiments of the present invention to provide alternative imaging especially medical imaging system and methods. More particularly, the present invention relates to the field of hybrid Single Photon Emission Computed Tomography (SPECT) and Magnetic Resonance Imaging (MRI) imaging systems, methods and software. In embodiments the present invention provides a molecular gradient coil for hybrid SPECT/MRI having an advantage of a good, e.g. optionally improved with respect to some prior art, sensitivity and/or spatial resolution and/or uniformity.

It is an advantage of embodiments of the present invention that simultaneous imaging of function and anatomy can be performed.

It is an advantage of embodiments of the present invention that the detection system can be placed close to the object of interest to be imaged, even for objects substantially smaller or larger than a mouse.

It is an advantage of embodiments of the present invention that sensitivity of the detection system can be increased.

It is an advantage of embodiments of the present invention that a better spatial resolution can be obtained.

It is an advantage of embodiments of the present invention that the required radiation dose may be reduced.

It is an advantage of embodiments of the present invention that it is possible to dynamically follow rapid changing tracer distributions over time in an object.

It is an advantage of embodiments of the present invention that scan time can be reduced.

It is an advantage of embodiments of the present invention that more uniform images can be produced.

It is an advantage of embodiments of the present invention that soft-tissue contrast can be increased.

It is an advantage of embodiments of the present invention that tracers with longer half-lives can be imaged.

It is an advantage of embodiments of the present invention that long time follow-up is possible in vivo.

It is an advantage of embodiments of the present invention that no wide bore MRI system is required.

It is an advantage of embodiments of the present invention that the original MRI bore size is not reduced.

It is an advantage of embodiments of the present invention that no moving detector parts are required.

It is an advantage of embodiments of the present invention that no subject motion is required.

The above objective is obtained by a hybrid detection device according to the present invention.

The present invention relates to a detection device for hybrid detection of photons, in particular gamma photons and of proton spins, in particular RF-waves. The detection device may for instance be used in SPECT/MRI imaging systems, wherein gamma photons escape from an object to be imaged and proton spins are detected using RF-antennas. The detection device according to embodiments of the present invention comprises a molecular gradient coil. According to embodiments of the present invention, the detection device comprises at least one molecular imaging device. According to embodiments of the present invention, the molecular gradient coil comprises the at least one molecular imaging device. According to embodiments of the present invention the molecular imaging device may be attached to or embedded in the molecular gradient coil. According to embodiments of the present invention, a molecular imaging device can be a SPECT imaging system. According to embodiments of the present invention, a molecular gradient coil may comprise at least a set of coil windings for the generation of three orthogonal magnetic gradient fields. According to embodiments of the present invention, the molecular gradient coil may comprise second order shimming coil windings. According to embodiments of the present invention, the molecular gradient coil may contain shielding coil windings. According to embodiments of the present invention, the molecular gradient coil may be a split molecular gradient coil, i.e. a molecular gradient coil comprising at least two axial parts as is shown for instance on FIG. 3B. According to embodiments of the present invention, at least one molecular imaging device may be disposed in the gap between the at least two parts of the split molecular gradient coil..

According to embodiments of the present invention, the volume of the positioning space, i.e. the space wherein the object to be imaged can be positioned, may be defined by the RF-coil. According to embodiments of the present invention, the RF-coil may be geometrically designed to fit the inside dimensions of the molecular imaging device. The dimensions of the positioning space can be chosen in such a way that an object can be positioned very close to the scintillating material, hereby reducing the spread of the gamma photons and increasing the sensitivity of the detection system.

According to embodiments of the present invention, the molecular imaging device can be a SPECT imaging system comprising collimators. In one embodiment, these collimators can consist of pure tungsten to minimize susceptibility artefacts. In one embodiment, the collimators can be made of paramagnetic materials other than tungsten. In one embodiment, the collimator can be a multi-lofthole collimator as is for instance described in WO2011/070123 - see FIG. 4A and FIG. 4B. In one embodiment, the collimator can be produced by additive manufacturing techniques. In one embodiment, the multi-lofthole collimator may comprise collimating apertures which allow for at least 32 projections onto the detector without moving the collimator or detector. Preferably at least 60 different projections are taken from the object in order not to have reconstruction artefacts. 70, 80, 90, 100 or more projections may be used in accordance with embodiments of the present invention. In one embodiment of the invention, the projections may comprise overlapping and non-overlapping projections. In one embodiment of the invention, each of the projections are non-overlapping projections. In one embodiment of the present invention, at least one or each of the collimating apertures of the multi-lofthole collimator allows for multiple projections on the same detector area. In one embodiment of the present invention, the molecular imaging device has a limited axial length. The axial length may be chosen to fit between at least two parts of a split molecular gradient coil. The axial length may for instance be at most 100 mm, preferably at most 50 mm.

In one embodiment of the present invention, the molecular imaging device has a limited radial length. The radial length of the molecular imaging device may for instance be at most 150mm in order to fit in the inside of a routinely used MRI scanner.

In one embodiment of the present invention, the molecular imaging device can be a SPECT imager equipped with radiation detectors in the form of scintillation detectors. In one embodiment, the radiation detectors can be solid-state radiation detectors. In one embodiment, the collimator may fill the space between the positioning space and the radiation detectors.

In one embodiment, the positioning space is accessible from outside from at least one side, allowing an object to be positioned inside the positioning space in a simplified way. In one embodiment, the positioning space is accessible from outside from at least two sides, for instance from at least two opposing sides.

According to embodiments of the invention, the molecular imaging device works in minification mode. According to embodiments of the present invention, the molecular imaging device has a limited footprint, enabling integration between the split gradient coils.

The detection device according to the present invention further advantageously comprises at least one read-out device, provided for converting the scintillating signals in usable data for image reconstruction. Such a read-out device may for instance take the form of a Silicon Photo Multiplier.

Features of different embodiments may be combined as will be apparent by the skilled person and not merely as indicated in the present description.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a two-dimensional representation of a pinhole collimator. In FIG. 1A a pinhole collimator magnifies an object onto the detector. This is achieved by making h larger than d. In FIG. 1B h < d and the object is minified onto the detector.
FIG. 2 shows a conventional MRI scanner
FIG. 3A shows an axial cross section of a conventional MRI scanner, while in FIG. 3B the gradient coil array is split to allow for space to insert the SPECT detectors and collimators as used in embodiments of the present invention.
FIG. 4 shows a multi-lofthole collimator as can be used in a detection device according to the present invention
FIG. 5 shows an embodiment of a detection device according to the present invention.
FIG. 6 shows an example of a SPECT system suitable for integration with MRI in accordance with an embodiment of the present invention. The object or animal may be inserted in the central opening. The pentagonal multi-lofthole collimator can be identified. Also the five individual detectors are drawn. Total height may be for instance 10 cm.

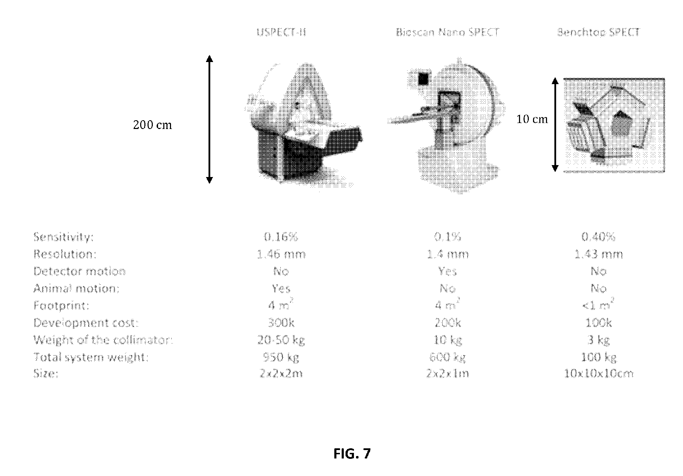

FIG. 7 shows a comparison between known systems and an embodiment of the present invention which is shown on the far right.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Embodiments of the present invention comprise a SPECT imager such as a microSPECT imager comprising a multi-lofthole collimator 1 which is suitable for integration into an MRI imaging device. The SPECT imager can be a pre-clinical SPECT imager. An embodiment of the present invention comprises a multi-lofthole collimator 1 and a plurality of radiation detectors 2 such as for instance five detectors. The radiation detectors 2 are preferably equally spaced over 360 degrees around the positioning space, i.e. test chamber, in which an object 3 is positioned. In a less preferred embodiment of the present invention the SPECT imager comprises one multi-pinhole collimator coupled to a single detector (MLSD) being equivalent to a multi-detector, e.g. five-detector system, by rotating the object under investigation under a number, e.g. five different discrete angles.

A multi-lofthole collimator 1as used in a detection device according to an embodiment of the present invention can be as described in and as designed in accordance with WO 2011/070123 which is incorporated herewith in its entirety. The collimator is made from a collimator material and has a plurality of collimator holes defined by the surrounding collimator material. Each collimator hole defines an aperture and an entrance opening and exit opening through which radiation can enter respectively leave the collimator, whereby the volume of the collimator hole between the aperture and at least one of the entrance opening and/or exit opening is shaped such that there is at least one cross-section of the hole between the aperture and the entrance opening and/or the exit opening, the cross-section being taken parallel with the aperture, such that the shape of the cross-section of the hole is a non-affine transform of the shape of the aperture. The cross-section may be between the aperture and a bottom surface through which radiation can leave the collimator. The volume of the collimator hole between the aperture and the entrance or the exit opening may differ from a conical shape. The volume of the collimator hole between the aperture and the bottom surface may be limited by a circular-shaped surface area on one side, e.g. the aperture, and by a surface area comprising at least one corner at another side. The shape of the area of the entrance opening and/ or exit opening defining the entrance area for receiving radiation or defining the exit area for radiation leaving the collimator hole may comprise at least one corner. A detector using such a collimator may have high sensitivity for geometrical photons that have a line-of -flight from the aperture towards the detector and low sensitivity for geometrical photons that have a line-of -flight from the aperture towards a point outside the detector area. Geometrical photons thereby are photons which do not penetrate.

The shape of the area of the entrance and/ or exit opening, e.g. of the bottom surface defining the exit area for radiation leaving the collimator hole, may be polygonal, especially a polygon that can be tiled without overlapping such as a rectangular shape. For example, the shape of the entrance opening or exit opening, e.g. of the area of the bottom surface defining the exit area for radiation leaving the collimator hole, may be rectangular. The collimator is preferably adapted for operating with a detector having a non-circular shaped detection area, wherein the volume of the collimator hole between the aperture and the bottom surface may be determined taking into account the shape of a detection area and/or wherein the volume of the collimator hole between the aperture and the entrance opening is determined taking into account the shape of a detection area.

The collimator has a plurality of collimator holes, whereby the different collimator holes are arranged for irradiating different areas of the detection surface, the different areas filling the detector high sensitivity surface overall for at least 80% advantageously at least 90% and the different areas overlapping with each other over at most 20% advantageously at most 10% of their total surface.

Selecting a degree of sensitivity may be performed by adapting the entrance/ exit surface as function of the intersections of the cones with the selected top or bottom surface. The collimator may be adapted for irradiating a predetermined detection surface and the outcoupling surface of the collimator may advantageously be adapted so that a larger detection surface is covered without increasing the overlap than would be obtained using a pinhole collimator

The collimator may be embedded in a radiation detection system. In one embodiment of the present invention, at least one or each of the collimating apertures of the multi-lofthole collimator allows for multiple projections on the same detector area. In one embodiment of the present invention, the molecular imaging device has a limited axial length. The axial length may be chosen to fit between at least two parts of a split molecular gradient coil. The axial length may for instance be at most 100 mm, preferably at most 50 mm.

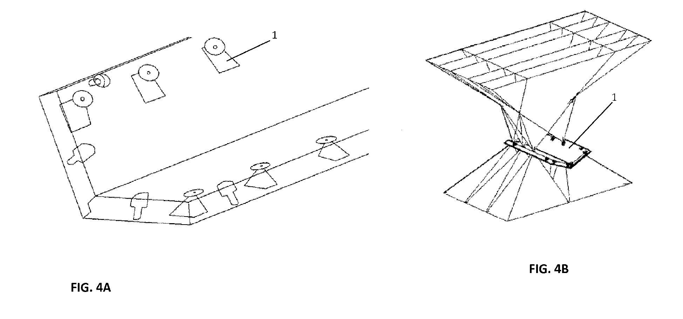

An example of a collimator that can be used with embodiments of the present invention is shown schematically in FIG. 4A and FIG. 4B. This collimator is designed in such a way that a detector is used as area-efficient as possible without radiating outside the detector FIG. 4A illustrates a front side view of a collimator with a plurality of collimator holes. In the present example, the collimator holes have a complex volume at one side of the aperture, defined by the aperture and rectangular shaped exit surfaces for the collimator holes. FIG. 4B illustrates an example of detector irradiation and field of view of an exemplary collimator as indicated in FIG. 4A.

In one embodiment of the present invention, the molecular imaging device has a limited radial length. The radial length of the molecular imaging device may for instance be at most 150mm in order to fit in the inside of a routinely used MRI scanner.

Embodiments of the present invention provide a stationary system, i.e. one that takes images of a subject around a significant part of 360° without rotations being necessary. An advantage of embodiments of the present invention is that sufficient angular samples are available to reduce or prevent artifacts in the reconstructed images. For example multiple loft holes such as 20 loftholes per detector are combined with multiple detectors such as 5 detectors. In total, the field-of-view is then seen from very many, e.g. 100 different angles. Preferably there should be more than 60 pinholes in total, e.g. more than 75, 80, 90 or 100.

An imager according to embodiments of the present invention may be a benchtop SPECT imager that can be combined with an MRI imager. An MRI scanner that can be used with the present invention can include a main superconducting magnet 5 for producing a high stationary and uniform magnetic field (e.g. 1.5T, 3T or 7T) within the central opening or bore of the scanner. Inside this main magnet, field gradient coils 6', 6 are placed for the purpose of three-dimensional imaging. This coil array usually has a cylindrical shape and decreases the initial diameter of the bore to a smaller value. A third important component of an MRI coil is the send/receive coil or RF coil 7 that is used to excite the protons and sequentially, to pick up their response signal. a molecular gradient coil comprises at least a set of coil windings for the generation of three orthogonal magnetic gradient fields. According to embodiments of the present invention, the molecular gradient coil comprises second order shimming coil windings. According to embodiments of the present invention, the molecular gradient coil contains shielding coil windings. According to embodiments of the present invention, the molecular gradient coil is preferably a split molecular gradient coil 6, i.e. a molecular gradient coil comprising at least two axial parts as is shown for instance on FIG 3B. According to embodiments of the present invention, at least one molecular imaging device is disposed in the gap between the at least two parts of the split molecular gradient coil..

According to embodiments of the present invention, the volume of the positioning space, i.e. the space wherein the object to be imaged can be positioned, is defined by the RF-coil 7. According to embodiments of the present invention, the RF-coil is geometrically designed to fit the inside dimensions of the molecular imaging device. The dimensions of the positioning space are preferably chosen in such a way that an object can be positioned very close to the scintillating material, hereby reducing the spread of the gamma photons and increasing the sensitivity of the detection system.

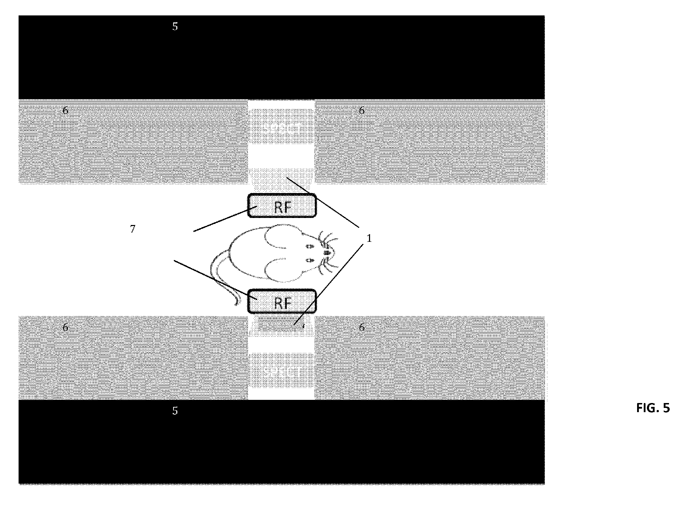

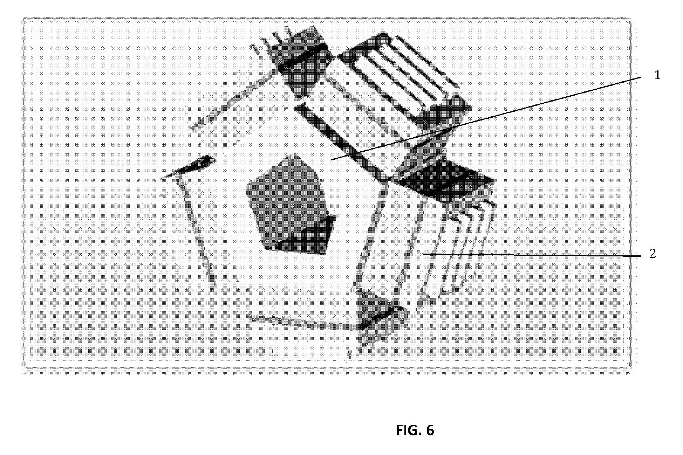

An example of SPECT imaging system suitable for integration into an MRI according to an embodiment of the present invention can be found in FIG. 5 and FIG. 6.

By placing the detector closer to the pinholes, more pinholes can be used per detector. The multi-lofthole design may for instance use 20 loftholes that simultaneously irradiate a single detector. A complete stationary small microSPECT system may comprise five detectors equipped with multi-lofthole collimators as shown in FIG. 6. A total of 100 loftholes can thus be used, assuring sampling completeness and high sensitivity without the need for movement of the animal and/or system during the acquisition. The present invention may comprise a multi-lofthole collimator as shown in FIG. 6. For the production of the multi-lofthole collimator a variety of manufacturing techniques can be used such as by milling or by a rapid prototyping technique such as a layered manufacturing technique. The collimator is preferably made from an MR compatible material such as Tungsten. The manufacturing can be controlled according to the quality of collimating of gamma rays, e.g. unwanted photon penetration can be measured with different energy gamma rays.

This small animal SPECT imager aims at bringing the technology of molecular imaging closer to the researcher. It is an advantage of embodiments of the present invention that a benchtop system can be provided that is less expensive compared to prior art devices.

Embodiments of the present invention may comprise manufacture of a plurality of detectors combined with the multi-lofthole collimator 1 as well as electronics, photo-detector for imaging the detector output, scintillator. The detector can be a digital radiation detector module. The detector can be a scintillation detector.. The detector should preferably be designed for SPECT applications allowing measurement of the energy and the position of gamma rays in the range from 20 keV to 600 keV. The detector may also include or be used with suitable electronic circuits (e.g. ASICs) for the processing of the currents from pixels and provide information on energy, position, and time. The signal processing on the electronic circuitry may include amplification, filtering, discrimination, and multiplexing of analog and digital data. An electronic readout is also provided. The detection device according to the present invention further advantageously comprises at least one read-out device, provided for converting the scintillating signals in usable data for image reconstruction. Such a read-out device may for instance take the form of a Silicon Photo Multiplier.

Preferably each detector is calibrated by a one-time detector positioning and energy calibration and a uniformity map recorded. Next, the multi-lofthole collimator may be positioned in front of the detector and performance measurements performed suitable for quality control. Images from phantoms can be used for resolution, uniformity and sampling completeness and the sensitivity could be adapted to match the pre-imposed specifications. The multiple detectors are arranged equally around 360°, e.g. five into a pentagonal structure as shown in FIG. 6.

While the invention has been illustrated and described in detail in the drawings and foregoing description, such illustration and description are to be considered illustrative or exemplary and not restrictive. The invention is not limited to the disclosed embodiments.
The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

## Claims

1. A detection device for hybrid detection of photons, in particular gamma photons and of proton spins, RF-waves, the detection device further comprising a molecular gradient coil and at least one molecular imaging device, the molecular gradient coil being a split molecular gradient coil (6) comprising at least two axial parts and the at least one molecular imaging device being disposed in the gap between the at least two parts of the split molecular gradient coil.

2. The detection device according to claim 1, wherein the detection device is a SPECT/MRI imaging system.

3. The detection device according to any previous claim wherein the molecular imaging device is a SPECT imaging device.

4. The detection device according to any previous claim wherein the molecular gradient coil comprises at least a set of coil windings for the generation of three orthogonal magnetic gradient fields.

5. The detection device according to any previous claim wherein the molecular gradient coil comprises second order shimming coil windings.

6. The detection device according to any previous claim wherein the molecular gradient coil comprises shielding coil windings.

7. The detection device according to any previous claim, the detection device further comprising an RF-coil (7), the RF-coil defining a volume wherein the object to be imaged can be positioned.

8. The detection device according to claim 7, wherein the RF-coil (7) is adapted to fit inside dimensions of the molecular imaging device.

9. The detection device according to any previous claim wherein the molecular imaging device is a SPECT imaging system comprising collimators (1,1').

10. The detection device of claim 9 wherein at least one of the collimators is a multi-lofthole collimator (1).

11. The detection device according to claim 10, wherein the at least one multi-lofthole collimator comprises collimating apertures which allow for at least 32 projection onto a detector without moving the collimator or detector.

12. The detection device of any previous claim wherein the molecular imaging device is adapted to have a limited axial length such that it fits between at least two parts of a split molecular gradient coil (6), for example having an axial length at most 100 mm, preferably at most 50 mm.

13. The detection device according to any previous claim, the molecular imaging device having a radial dimension, the radial dimension being at most 150mm.

14. The detection device according to any previous claim wherein the molecular imaging device is a SPECT imaging device comprising radiation detectors (2) and collimators (1, 1'), and wherein the collimators fill a space between a positioning space, wherein an object to be imaged (3) can be positioned, and the radiation detectors.

15. The detection device according to any previous claim wherein the molecular imaging device is adapted to work in minification mode.
